# EUROPÄISCHE PATENTSCHRIFT

(11) **EP 2 154 271 B1**
(45) Veröffentlichungstag und Bekanntmachung des Hinweises auf die Patenterteilung: **25.07.2012**
(21) Anmeldenummer: 08161254.1
(22) Anmeldetag: 28.07.2008
(51) Int. Cl.: C30B 25/14, C30B 29/40, C23C 16/455, C23C 16/448, C23C 16/34

(54) **Vorrichtung zur Züchtung von III-Nitrid-Volumen-Kristallen**
Apparatus for growing III-nitride-bulk crystals
Dispositif pour la croissance de cristaux de III-nitrure volumineux

(43) Veröffentlichungstag der Anmeldung: 17.02.2010
(73) Patentinhaber: Forschungsverbund Berlin E.V., 12489 Berlin (DE)
(72) Erfinder: Fornari, Roberto, Prof. Dr., 12489 Berlin (DE)
(74) Vertreter: Gulde, Klaus W.

(56) Entgegenhaltungen:
- ATTOLINI G ET AL: "A vertical reactor for deposition of gallium nitride" MATERIALS CHEMISTRY AND PHYSICS ELSEVIER SWITZERLAND, Bd. 66, Nr. 2-3, 16. Oktober 2000 (2000-10-16), Seiten 213-218, XP002502840 ISSN: 0254-0584
- CAI ET AL: "Thermodynamic and kinetic study of transport and reaction phenomena in gallium nitride epitaxy growth" INTERNATIONAL JOURNAL OF HEAT AND MASS TRANSFER, PERGAMON PRESS, GB, Bd. 51, Nr. 5-6, 18. Januar 2008 (2008-01-18), Seiten 1264-1280, XP022490264 ISSN: 0017-9310
- SICHE ET AL: "Growth of GaN crystals from chlorine-free gas phase" JOURNAL OF CRYSTAL GROWTH, ELSEVIER, AMSTERDAM, NL, Bd. 310, Nr. 5, 24. Januar 2008 (2008-01-24), Seiten 916-919, XP022492823 ISSN: 0022-0248
- HUAQIANG WU ET AL: "Thick GaN layer grown by Ga vapor transport technique" HIGH PERFORMANCE DEVICES, 2004. PROCEEDINGS. IEEE LESTER EASTMAN CONFE RENCE ON RENSSELAER POLYTECHNIC INST., TROY, NY, USA 4-6 AUG., 2004, PISCATAWAY, NJ, USA,IEEE, 4. August 2004 (2004-08-04), Seiten 121-125, XP010857766 ISBN: 978-981-256-196-1
- SYTNIEWSKI L J ET AL: "CFD optimisation of up-flow vertical HVPE reactor for GaN growth" JOURNAL OF CRYSTAL GROWTH, ELSEVIER, AMSTERDAM, NL, Bd. 310, Nr. 14, 1. Juli 2008 (2008-07-01), Seiten 3358-3365, XP022715399 ISSN: 0022-0248 [gefunden am 2008-04-18]

## Beschreibung

Die Erfindung betrifft eine Vorrichtung und ein Verfahren zur Züchtung von III-Nitrid-Volumen-Kristallen gemäß den in den Oberbegriffen der Ansprüche 1 und 15 genannten Merkmalen.

Volumenkristalle aus III-Nitrid-Verbindungen, beispielsweise Galliumnitrid (GaN), sind notwendig, um gerichtete Substrate für die anschließende Abscheidung epitaktischer Strukturen für elektronische und opto-elektronische Bauelemente zu fertigen. Heutzutage werden derartige auf Indium-Gallium-Nitrid (InGaN), oder Aluminium-Gallium-Nitrid (AlGaN) und auch auf quarternären Legierungen basierende Strukturen heteroepitaktisch auf Fremdsubstraten - gewöhnlich Oxide oder Siliziumkarbid - gezüchtet. Jedoch führt der Unterschied zwischen Gitterparameter und Wärmeausdehnungskoeffizient zwischen den gewünschten Schichten und den zurzeit verfügbaren Substraten zu einer hohen Dichte kristallographischer Defekte (hauptsächlich Versetzungen), welche die Leistung der elektronischen Bauelemente letztlich einschränken. Dies ist besonders in der Optoelektronik von Bedeutung, da solche Defekte eine von der Strahlungsrekombination verschiedene Rekombination der Träger bewirken und auf diese Art die Photonenausbeute sowohl von LED als auch von Lasern vermindern. Weiterhin schränken solche Defekte auch die Lebensdauer der Bauelemente ein und verursachen erhebliche Einschränkungen bei der Herstellung betriebssicherer, effizienter Laser. Die Verfügbarkeit von GaN-Substraten würde die homoepitaktische Abscheidung von Strukturen ermöglichen und die große Beanspruchung während der Abkühlungsphase, die auf die epitaktische Abscheidung folgt, vermeiden. Die Homoepitaxie auf durch Hochdruck-Lösungszüchtung erhaltenen winzigen GaN-Substraten (Bereiche < 1 cm²) hat gezeigt, dass die Versetzungsdichte in diesem Fall um etwa drei Größenordnungen reduziert wird, so dass auf diese Weise die Idee von Lasern mit längerer Lebensdauer realistischer wird. Deshalb ist ein großer Teil der Forschung dem Ziel gewidmet, ein robustes und kostengünstiges Verfahren für die Produktion von Volumen-III-Nitrid-Kristallen, insbesondere Volumen-GaN, trotz der sehr ungünstigen thermodynamischen Eigenschaften dieses Halbleiters (Schmelzpunkt > 2500° C, Dampfdruck am Schmelzpunkt > 40 kbar), aufgrund derer die Anwendung traditioneller Schmelzzüchtungsverfahren nicht möglich ist, zu entwickeln.

Eine Vielzahl von Verfahren ist mit dem Ziel erprobt worden, hochwertiges Volumen-GaN zu produzieren: Hochdruck-Lösungszüchtung aus Ga-Schmelze (Madar R et al., J. Crystal Growth 31 (1975), 197; Karpinski et al., Mater. Res. Soc. Symp. Proc 22 (1984) 73-76; Porowski S et al., J. Crystal Growth 178 (1997), 174); Atmosphärendruck-Lösungszüchtung (Kawamura F et al., Jpn J. Appl. Phys. 42 (2003), L879; Hussy S et al., J. Crystal Growth 310 (2008), 738); ammonothermale Lösungszüchtung (Yoshikawa A et al., J. Crystal Growth 260 (2004), 67; Hashimoto T et al., Nature Materials 6 (2007), 568); Fluxzüchtung (Song et al., J. Crystal Growth 247 (2003), 275; Shin T I et al., J. Crystal Growth 292 (2006), 216); Sublimation von GaN-Pulver (Kamler G et al., J. Crystal Growth 212 (2000), 39). Es muss gesagt werden, dass diese Verfahren in den meisten Fällen kleine Proben ohne industrielle Relevanz geliefert haben. Nur das HVPE-Verfahren(Hydride Vapor Phase Epitaxy; Hydridgasphasenepitaxie) hat gezeigt, dass sich Schichten mit einem Durchmesser von 50 mm und bis zu einigen Millimetern Dicke erreichen lassen (Shibata T et al., J. Crystal Growth 189/190 (1998), 67; Hasegawa et al., Phys. Stat. Sol. A 176 (1999), 421; Miskys C R et al., Phys. Stat. Sol. C 6 (2003), 1627 ; Lucznik et al., Phys. Stat. Sol. C 3 (2006), 1453). In den meisten Fällen beschränkte sich jedoch das Züchten auf Schichten in einer Dicke von 300-500µm, die anschließend von den Ausgangsheterosubstraten getrennt wurden.

Beim HVPE-Verfahren wird das Gallium als Galliumchlorid in den Reaktor transportiert, wo es mit einem Strom reinen Ammoniaks zu GaN reagiert. Ein Nachteil dieses Verfahrens ist, dass als Nebenprodukt der Reaktion eine große Menge an Ammoniumchlorid entsteht. Diese Substanz ist ein Pulver, das den Vertikal-Reaktor kontaminiert und nach einigen Stunden sogar Probleme an Entlüftungsleitung und Pumpenanlage verursachen kann. Außerdem verwendet die HVPE-Methode HCl und sehr große Mengen an Ammoniak, wodurch sich natürlich die Betriebskosten dieses Verfahrens erhöhen. Schließlich ist die Endqualität der einzelnen freistehenden Wafer für hoch anspruchsvolle Anwendungen, wie zum Beispiel Laserfertigung, normalerweise ungenügend, falls nicht sehr spezielle Substrate - so genannten ELOG-Matrizen - verwendet werden.

Siche D. et al., J. Crystal Growth 310(2008) 916-919 offenbart eine Vorrichtung zur Züchtung von GaN-Kristallen mit der Erzeugung eines Metalldampfes aus einer Metallschmelze.

Der Erfindung liegt die Aufgabe zugrunde, eine Vorrichtung anzugeben, mit denen die Züchtung von III-Nitrid-Volumen-Kristallen kosteneffizient und in guter Qualität ermöglicht werden kann.

Weiterhin ist es Aufgabe der Erfindung, unerwünschte chemische Reaktionen innerhalb des Reaktors zu vermeiden.

Die Aufgabe wird gelöst mit einer Vorrichtung mit den Merkmalen des Anspruches 1.

Mit dieser erfindungsgemäßen Vorrichtung wird ein Verfahren zur Züchtung von III-Nitrid-Volumen-Kristallen durchgeführt, bei denen ein gasförmiges Quellenmaterial und ein Trägergas in einen Vertikal-Reaktor gebracht werden, in dem Vertikal-Reaktor ein Metalldampf aus einer Metall-Schmelze erzeugt wird, eine Verbindung aus Metalldampf und Quellenmaterial gebildet wird und diese auf einem Substrat abgeschieden wird, ist dadurch gekennzeichnet, dass das Quellenmaterial und der durch einen Trägergasstrom mitgeführte Metalldampf voneinander so getrennt zu einer Oberfläche des Substrates geführt werden, dass die Verbindung aus Quellenmaterial und Metalldampf erst auf dem Substrat gebildet und dort zur Abscheidung gebracht wird, oder dass die Verbindung aus Quellenmaterial und Metalldampf unmittelbar vor dem Auftreffen auf das Substrat gebildet wird und dort zur Abscheidung gebracht wird.

Mit der Erfindung wird in einer Lösung die direkte und gleichzeitige senkrechte Injektion von Quellenmaterial und Metalldampf zum rotierenden Substrat ermöglicht. Hierbei wird gewährleistet, dass die Reaktanten, der Metalldampf und das gasförmiges Quellenmaterial erfindungsgemäß so lange voneinander getrennt bleiben, bis sie auf die Substratoberfläche auftreffen. Es treten vor dem Auftreffen der Reaktanten auf die Substratoberfläche keine chemischen Reaktionen auf, insbesondere wird vor dem Auftreffen keine Verbindung aus Quellematerial und Metalldampf gebildet.

Unterhalb und oberhalb des Substrates bedeutet, dass die Zuführung der gasförmigen Reaktanten Quellenmaterial und Metalldampf auf die Oberfläche des Substrates je nach Anordnung der Verdampfungszelle innerhalb der erfindungsgemäßen Vorrichtung erfolgt, nämlich in einem Fall entgegen der Schwerkraft - die Substratoberfläche befindet sich oberhalb des Gas-Ausrittes und des Dampf-Austrittes - und im anderen Fall erfolgt die Zuführung mit der Schwerkraft - die Substratoberfläche befindet sich unterhalb des Gas-Austrittes und des Dampf-Austrittes.

In der anderen Lösungsvariante wird die Verbindung aus Quellenmaterial und Metalldampf bereits unmittelbar vor dem Substrat gebildet und dann auf der Substratoberfläche zur Abscheidung gebracht. In diesem Fall werden die Reaktanten nicht individuell auf der Substratoberfläche adsorbiert.
Unmittelbar bedeutet, dass die gasförmigen Reaktanten beispielsweise in einem Bereich von etwa 1 bis 2 mm vor der Substratoberfläche zusammengeführt werden und die Verbindung aus Metalldampf und Quellenmaterial dementsprechend in diesem Bereich vor der Oberfläche des Substrates gebildet wird.

Weitere bevorzugte Ausgestaltungen der Erfindung sind in den Unteransprüchen enthalten.

Eine Ausgestaltung der erfindungsgemäßen Vorrichtung sieht vor, dass der Dampf-Austritt des Metalldampfes aus einem Austrittskanäle aufweisenden Graphit-Block gebildet ist.

Eine bevorzugte Ausgestaltung der erfindungsgemäßen Vorrichtung sieht vor, dass der Graphit-Block zumindest in einem Teilbereich Austrittskanäle für den Metalldampf aufweist.
Der Graphit-Block ist zylinderförmig und hat dementsprechend eine kreisrunde Querschnittsfläche.
Der Graphit-Block weist in einer Ausgestaltung nur in einem Teilbereich Austrittskanäle auf. Dieser Teilbereich, der die Austrittskanäle enthält, bildet den Dampf-Austritt. In einer anderen Ausgestaltung sind die Astrittskanäle über dem gesamten Graphit-Blockes verteilt. Durch die Austrittskanäle wird der Metalldampf mittels Trägergasstrom geführt. Gleichzeitig wird durch den erfindungsgemäßen Aufbau des Graphit-Blockes mit den Austrittskanälen sichergestellt, dass das Quellenmaterial nicht in die Verdampfungszelle hineingelangen kann.

In einer weiteren bevorzugten Ausgestaltung der erfindungsgemäßen Vorrichtung ist vorgesehen, dass der mit Austrittskanälen versehene Teilbereich des Graphit-Blockes des Dampf-Austrittes eine halbkreisrunde Querschnittsfläche bildet. Der Dampf-Austritt hat in einer bevorzugten Ausgestaltung einen halbkreisförmigen Querschnitt.

Der nicht mit Austrittskanäle versehene Teilbereich des Graphit-Block kann eine Dicke zwischen etwa 3 mm bis 15 mm aufweisen. Der andere Teilbereich, der mit Austrittskanäle versehen ist, kann eine Dicke von etwa 6 mm bis 20 mm aufweisen.

Eine nächste bevorzugte Ausgestaltung der erfindungsgemäßen Vorrichtung sieht vor, dass die Verdampfungszelle einen Schmelztiegel, einen oberhalb des Schmelztiegels angeordneten Dehnungsring und den darüber angeordneten, die Verdampfungszelle abschließenden Graphit-Block umfasst.
In der Verdampfungszelle wird der Metalldampf von Gallium, Aluminium oder Indium erzeugt, der dann mit Hilfe eines Trägergasstromes durch den speziell ausgestalteten Dampf-Austritt auf die Oberfläche des das Substrates geführt wird. Der Dehnungsring liegt auf dem Rand des Schmelztiegels auf und bildet mit diesem eine feste Einheit. Darüber ist der Graphit-Block angeordnet. Die Verdampfungszelle weist insgesamt eine zylinderförmige Gestalt auf.
Erfindungsgemäß stehen das Substrat und die Verdampfungszelle innerhalb des Vertikal-Reaktors in vertikaler Anordnung zueinander. Diese vertikale Züchtungsanordnung ermöglicht, dass der Metalldampf senkrecht auf die Substratoberfläche geführt werden kann.

Eine andere bevorzugte Ausgestaltung der erfindungsgemäßen Vorrichtung sieht vor, dass der Dehnungsring vertikal um eine Länge verstellbar ausgeführt ist.
Über den höhenverstellbaren Dehnungsring lässt sich ein definierter Abstand der Verdampfungszelle zum Substrat einstellen. Beispielsweise kann ein Abstand zwischen Substrat und Dampf-Austritt im Bereich zwischen 1 und 100 mm eingestellt werden.

In einer anderen bevorzugten Ausgestaltung der erfindungsgemäßen Vorrichtung ist vorgesehen, dass die Verdampfungszelle einen Schmelztiegel umfasst, in den ein von Tiegel-Innen-Wänden umgebender Hohlraum zur Aufnahme des Graphit-Blockes eingelassen ist, der Graphit-Block den Schmelztiegel nach unten abschließt und der Schmelztiegel einen Schmelztiegeldeckel aufweist.
Bei dieser Ausgestaltung der Verdampfungszelle weist der Schmelztiegel Doppelwände auf, wobei der Graphit-Block zwischen den Tiegel-Innen-Wänden angeordnet ist. Bei einer derartigen Anordnung der Verdampfungszelle wird eine vertikale Züchtungsanordnung ermöglicht, bei der das Substrat senkrecht unterhalb des Schmelztiegels angeordnet werden kann. Das Trägergas wird über eine Zuführung und über zwei oder vier symmetrisch angeordnete Trägergas-Auslässe über der Schmelze eingeleitet. Diese Ausgestaltung hat den Vorteil, dass sich die heißeste Zone über dem Substrat mit niedriger Temperatur befindet, was die Entstehung konvektiver Strömungen im Vertikal-Reaktor verhindern kann.

Eine nächste bevorzugte Ausgestaltung der erfindungsgemäßen Vorrichtung sieht vor, dass der Schmelztiegel, der Dehnungsring, der Graphit-Block und der Schmelztiegeldeckel der Verdampfungszelle aus Graphit gebildet sind, wobei der Graphit mit einer Siliziumcarbid- oder Siliziumnitrid-Beschichtung versehen ist.
Die Teile der Verdampfungszelle wie Schmelztiegel, Dehnungsring und Dampf-Austritt bestehen vorzugsweise aus beschichtetem Graphit. Die Beschichtung ist innen und außen an diesen Teilen angebracht.

In einer weiteren bevorzugten Ausgestaltung der erfindungsgemäßen Vorrichtung ist vorgesehen, dass der Schmelztiegel mit einer Trägergaszuführung verbunden ist.

Über die Trägergaszuführung wird das Trägergas in die Verdampfungszelle geleitet. Der Metalldampf wird mittels dieses Trägergases zur Oberfläche des Substrates transportiert. Die Trägergaszuführung befindet sich nahe am Schmelztiegel, um das Trägergas vor dem Vermischen mit dem Metalldampf vorzuwärmen.

Eine weitere bevorzugte Ausgestaltung der erfindungsgemäßen Vorrichtung sieht vor, dass der Gas-Austritt als ein Hohlkörper mit Austrittskanälen oder als Flachdüse ausgebildet ist.
Die Querschnittsfläche des Gas-Austrittes ergibt in einer Ausgestaltung eine halbkreisrunde Form. Über die Austrittskanäle wird das gasförmige Quellenmaterial senkrecht auf das Substrat geführt.
In dem Fall, dass der Gas-Austritt als Hohlkörper ausgestaltet ist, ist er am Dampf-Austritt der Verdampfungszelle derart angeordnet, dass Dampf-Austritt und Gas-Austritt zusammen eine kreisrunde Querschnittsfläche bilden, die vorzugsweise der Größe und Form der kreisrunden Substratoberfläche entsprechen soll.
In dem anderen Fall, dass der Gas-Austritt als Flachdüse ausgebildet ist, wird das Quellematerial in horizontaler Richtung entlang der Oberfläche des Substrates injiziert.

Eine andere bevorzugte Ausgestaltung der erfindungsgemäßen Vorrichtung sieht vor, dass der Gas-Austritt mit einer Quellenmaterial-Zuführung verbunden ist.
Über diese Zuleitung wird das gasförmige Ammoniak als Quellenmaterial in den Vertikal-Reaktor eingeleitet, welches dann, entsprechend der Ausgestaltung des Gas-Austrittes, zum Substrat geführt wird.
Der Gas-Austritt und die Quellenmaterial-Zuführung bestehen aus Quarz.

Die Austrittskanäle des Dampf-Austrittes können einen Durchmesser von wenigstens 1 mm und eine Länge von wenigstens 5 mm aufweisen; die Austrittskanäle des Gas-Austrittes können einen Durchmesser von wenigstens 1 mm und eine Länge von wenigstens 2 mm aufweisen. Die Austrittskanäle weisen vorzugsweise diejenigen Abmaße hinsichtlich Länge und Durchmesser auf, die erforderlich sind, um die Diffusion des Quellenmaterials in die Verdampfungszelle, d. h. in Richtung Schmelztiegel zu verhindern. Die Strömungsgeschwindigkeit des Trägergases wird auf Grundlage der Abmessungen der Austrittskanäle ausgewählt, um eine ausreichend hohe Transportgeschwindigkeit für den Metalldampf zu erreichen und eine Quellenmaterial-Gegenströmung zu verhindern.

Eine nächste bevorzugte Ausgestaltung der erfindungsgemäßen Vorrichtung sieht vor, dass die Anzahl der Austrittskanäle des Gas-Austrittes und die Anzahl der Austrittskanäle des Dampf-Austrittes gleich sind.
Die Austrittskanäle des Gas-Austrittes und des Dampf-Austrittes sind jeweils zahlenmäßig gleich. Im Falle der Ausgestaltung des Gas-Austrittes als Hohlkörper und des Dampf-Austrittes mit halbkreisförmigen Querschnitt sind die Austrittskanäle vorzugsweise jeweils im Halbkreis derart angeordnet, dass sie zusammen jeweils Kreise mit 3 bis 6 gleichweit entfernte volle Kreis-Umfänge mit abnehmenden Radius bilden. Es sind auch andere Anordnungsweisen der Austrittskanäle denkbar.

In einer weiteren bevorzugten Ausgestaltung der erfindungsgemäßen Vorrichtung ist vorgesehen, dass um die Verdampfungszelle herum eine Isolierung angeordnet ist.
Die Verdampfungszelle und insbesondere der Schmelztiegel ist innerhalb des Vertikal-Reaktors in eine Wärmeschutz-Isolierung eingebettet. Ebenso ist die Trägergasleitung in die Isolierung eingebettet.

In einer anderen bevorzugten Ausgestaltung der erfindungsgemäßen Vorrichtung ist vorgesehen, dass der Vertikal-Reaktor als ein mit einem Bornitridaufsatz verschließbaren Bornitridzylinder ausgeführt ist.
Der Vertikal-Reaktor wird im Wesentlichen von einem Bornitridzylinder gebildet, der mit einem Bornitridaufsatz verschlossen wird. Der Bornitridaufsatz enthält Austrittsöffnungen zur Abführung des Trägergases und der gasförmigen Nebenprodukte H₂ und N₂ der Abscheidungsreaktion.

Der Vertikal-Reaktor wird von einem Quarzzylinder und dieser von einer entlang des Quarzzylinders vertikal bewegbaren Wärmequelle umgeben. Die Wärmequelle dient der Beheizung der Verdampfungszelle, insbesondere des Schmelztiegels. Sie kann entlang des Quarzzylinders in vertikaler Richtung verstellt werden. Als Wärmequelle kann eine Hochfrequenz-Spule (HF-Spule) oder eine Widerstandsheizeinrichtung vorgesehen sein. Eine HF-Spule kommt in den Fällen zum Einsatz, wenn die Verdampfung Temperaturen von weit oberhalb 1000 °C verlangt, die mit Widerstandsheizern nicht mehr erreichbar sind.

Der Quarzzylinder wie auch der Bornitridzylinder und der Raum oberhalb des Schmelztiegels lassen sich vor Beginn des Züchtungsvorganges entleeren und mit Reingas durchspülen. Diese Maßnahmen und der Aufbau der erfindungsgemäßen Vorrichtung insgesamt ermöglichen, den Abscheidungsprozess zwischen subatmosphärischem und atmosphärischen Druck, zwischen 50 Pa und 101 kPa, auszuführen.

Der Quarzzylinder ist jeweils durch oben und unten angeordnete wassergekühlte Stahlflansche verschließbar.

Das Substrat wird über eine Halterung durch den oberen oder unteren Stahlflansch des Quarzzylinders in den Vertikal-Reaktor geführt. Es ist auf einer keramischen oder Graphit-Grundplatte drehbar angebracht, die durch einen Metallwiderstand beheizt wird, so dass auch das Substrat erhitzt werden kann. Mittels der vertikal verstellbaren Halterung kann ein Abstand des Substrates von dem Duschkopf eingestellt werden. Das Substrat hat vorzugsweise einen nach Form und Größe entsprechenden Querschnitt wie der (kreisrunde) Graphit-Block.
Das Substrat bildet die Keimfläche für den auf ihr aufwachsenden Kristall. Das Substrat muss eine zumindest sehr ähnliche Gitterstruktur wie der zu züchtende Kristall aufweisen. Entsprechend wird ein geeignetes Substratmaterial ausgewählt.

Innerhalb des Vertikal-Reaktors sind TemperaturMesseinrichtungen in Form von Thermoelementen angeordnet, über die die Temperaturregelung im Vertikal-Reaktor erfolgt.
Die Thermoelemente sind am Schmelztiegel und am Substrat angeordnet. Ein weiterer Temperaturregler kann die Ausführung verschiedener Programmsegmente, wie beispielsweise die Aufheizkurve, das Konstanthalten der Verdampfungstemperatur oder das Kühlen der Metall-Schmelze steuern und überwachen.

Eine bevorzugte Ausgestaltung des Verfahrens sieht vor, dass das Quellenmaterial und der Metalldampf jeweils senkrecht und unmittelbar auf das Substrat geführt werden. Unmittelbar bedeutet, dass sich die Reaktanten, das Ammoniak-Gas und der Metalldampf, nicht vor dem Auftreffen auf das Substrat reagieren können. Die Reaktanten bleiben voneinander getrennt, bis sie auf die Oberfläche des Substrates auftreffen, dort erst die Verbindung bilden und diese zur Abscheidung gebracht wird.

In einer weiteren bevorzugten Ausgestaltung des Verfahrens ist vorgesehen, dass das Quellenmaterial parallel entlang der Oberfläche des Substrates geführt und der Metalldampf senkrecht auf das Substrat geführt wird.
In diesem Fall werden die Reaktanten nicht einzeln auf der Oberfläche des Substrates adsorbiert, sondern ihre Verbindung. Unmittelbar vor dem Auftreffen auf der Oberfläche des Substrates bilden sie die Verbindung, die auf dem Substrat abgeschieden wird.

Das Quellenmaterial mit Hilfe eines Trägergasstromes zum Substrat geführt wird. Als Trägergas wird Stickstoff eingesetzt.

Die Züchtung des III-Nitrid-Volumen-Kristalles kann über eine Einstellung der Züchtungsparameter Züchtungszeit, Kristallabkühlungsgeschwindigkeit, Substratrotationsgeschwindigkeit, Züchtungstemperatur, Quellenmaterial- und Trägergasdurchsatz, Umgebungsgegendruck, Temperatur der Metall-Schmelze gesteuert werden.
So kann beispielsweise eine Substratrotationsgeschwindigkeit zwischen 5 bis 500 U/min, eine Züchtungstemperatur zwischen Raumtemperatur bis ca. 1800 °C, eine Kristallabkühlungsgeschwindigkeit von 2 bis 30 °C min⁻¹, ein Ammoniak- und Trägergasdurchsatz zwischen 50 bis 5000 Standardkubikzentimeter/min, eine Temperatur des Tiegels im Bereich von 500 - 2000 °C und ein Umgebungsgegendruck zwischen atmosphärischem Druck und 50 Pa eingestellt werden.

Die Erfindung wird nachfolgend in einem Ausführungsbeispiel und anhand von Zeichnungen näher erläutert. Es zeigen:
- Figur 1: eine schematische Schnitt-Darstellung einer Vorrichtung zur Züchtung von III-Nitrid-Volumen-Kristallen gemäß der Erfindung,
- Figur 2: eine schematische Darstellung eines Gas-Austrittes und eines Dampf-Austrittes nach Figur 1 in Draufsicht,
- Figur 3: eine andere Darstellung einer Vorrichtung zur Züchtung von III-Nitrid-Volumen-Kristallen in Schnitt-Ansicht,
- Figur 4: eine schematische Darstellung des Dampf-Austrittes und des Gas-Austrittes des nach Fig. 3 in Draufsicht,
- Figur 5: eine schematische Schnitt-Darstellung einer weiteren Vorrichtung zur Züchtung von III-Nitrid-Volumen-Kristallen,
- Figur 6: ein vergrößerter Ausschnitt des Bereiches einer Verdampfungszelle der Vorrichtung nach Fig. 5 und
- Figur 7: ein weiterer vergrößerter Ausschnitt des Bereiches der Verdampfungszelle einer weiteren Vorrichtung zur Züchtung von III-Nitrid-Volumen-Kristallen.

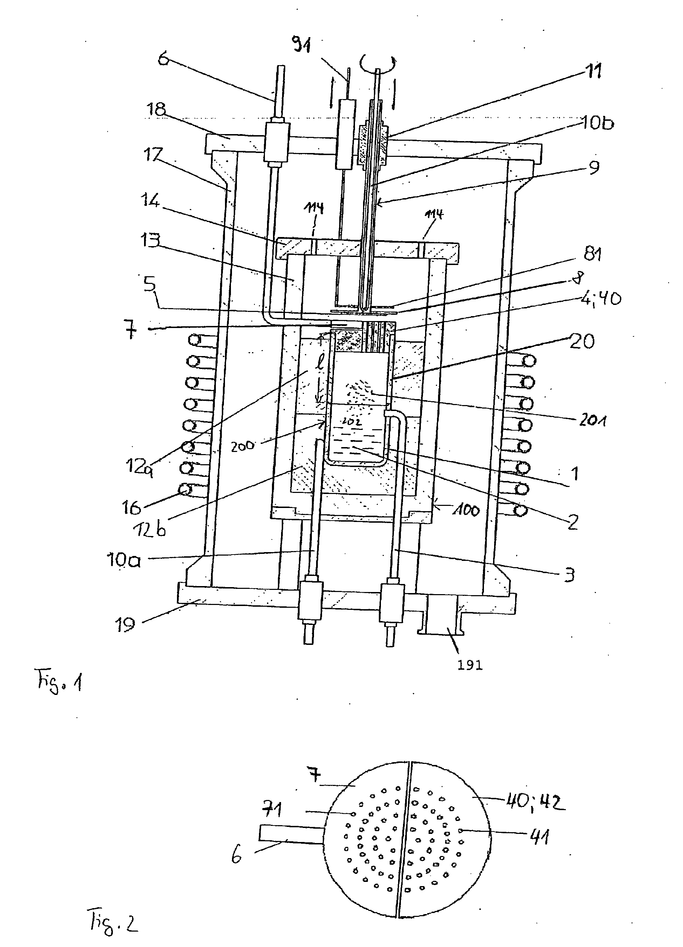

Figur 1 zeigt eine schematische Darstellung einer Vorrichtung zur Züchtung von III-Nitrid-Volumen-Kristallen gemäß der Erfindung. Die Vorrichtung nach Figur 1 weist im Wesentlichen einen innerhalb eines Quarzzylinders 17 angeordneten Vertikal-Reaktor 100 auf. Der Vertikal-Reaktor 100 wird von einem Bornitridzylinder 13 und einem nach oben abschließenden Bornitridaufsatz 14 gebildet. Um den Quarzzylinder 17 ist eine Wärmequelle 16 in Form einer HF-Spule angeordnet. Der Bornitridaufsatz 14 weist (insgesamt vier) Austrittsöffnungen 114 für ein Trägergas und die gasförmigen Nebenprodukte H₂ und N₂ einer Abscheidungsreaktion auf.
Innerhalb des Vertikal-Reaktors 100 sind eine Verdampfungszelle 200, die von einer Wärme-Isolierung 12a, 12b umgeben ist, und ein auf einer keramischen Grundplatte 8 versehenes Substrat 5 angeordnet, welches über einen Heizer 81 und einer elektrischer Heizerzuleitung 91 beheizbar ist. Das Substrat 5 und die Verdampfungszelle 200 sind im Wesentlichen senkrecht zueinander angeordnet. Die Grundplatte 8 wird über eine Halterung 9 gehaltert und innerhalb des Vertikal-Reaktors 100 vertikal beweglich geführt. Die Grundplatte 8 ist drehbeweglich ausgeführt, so dass das Substrat 5 rotieren kann. Die Rotation des Substrates 5 ermöglicht eine Halterdurchführung 11.

Die Verdampfungszelle 200 in Figur 1 umfasst einen Schmelztiegel 1, einen oberhalb des Schmelztiegels 1 angeordneten Dehnungsring 20, und einen oberhalb des Dehnungsringes 20 angeordneten Graphit-Block 4, der die Verdampfungszelle 200 abschließt. Der Graphit-Block 4 weist in einem Teilbereich 42 Austrittskanäle 41 auf. Der Teilbereich 42 des Graphit-Blockes 4, der die Austrittskanäle enthält, bildet den Dampf-Austritt 40 für einen Metalldampf 201.
Der Schmelztiegel 1 ist mit dem auf ihm aufgesetzten Dehnungsring 20 zu einer festen Einheit verbunden. Dampf-Austritt 40, Dehnungsring 20 und Schmelztiegel 1 bestehen aus beschichtetem Graphit. Der Dehnungsring 20 ist um eine Länge l vertikal verstellbar, wodurch ein definierter Abstand der Verdampfungszelle 200 zur Oberfläche des Substrates einstellbar ist.

Der Schmelztiegel 1 weist eine Trägergaszuführung 3 auf, die über die Verdampfungszelle 200 und Wärme-Isolierung 12a, 12b, durch den Vertikal-Reaktor 100 und durch einen den Quarzzylinder 17 zum Boden hin abschließenden Stahlflansch 19 geführt ist. Der Stahlflansch 19 sieht einen Evakuierungsstutzen 191 vor.
Die Trägergaszuführung 3 dient der Einleitung von Stickstoff in einen Gasraum 202 des Schmelztiegels 1, der eine Metall-Schmelze 2 enthält.

Unterhalb des Substrates 5 befindet sich am Dampf-Austritt 40 der Verdampfungszelle 200 ein Gas-Austritt 7 für das Quellenmaterial Ammoniak. Der Gas-Austritt 7 ist mit einer Quellenmaterial-Zuführung 6 für die Zuleitung des Ammoniaks in den Vertikal-Reaktor 100 verbunden. Die Quellenmaterial-Zuführung 6 verläuft durch den Vertikal-Reaktor 100 und über einen den Quarzzylinder 17 nach oben abschließenden Stahlflansch 18.

Der Quarzzylinder 17 ist von der vertikal beweglich angeordneten HF-Spule 16 derart umgeben, dass sich der Schmelztiegel 1 mit der Metallschmelze 2 in der heißesten Zone der HF-Spule befindet und die Temperaturen des Gas-Austrittes 7 und des Dampf-Austrittes 40 ebenfalls sehr hoch sind, so dass der Metalldampf 201 entlang der Austrittskanäle 41 nicht kondensiert.
Innerhalb des Vertikal-Reaktors 100 sind Temperaturmesseinrichtungen 10a, 10b in Form von Thermoelementen vorhanden, mit denen die Temperaturregelungen erfolgen.

Figur 2 zeigt eine schematische Darstellung des Gas-Austrittes 7 und des Dampf-Austrittes 40 nach Figur 1 in Draufsicht senkrecht zu Substrat 5. Dargestellt sind die geometrische Form und Anordnung des Dampf-Austrittes 40 und des Gas-Austrittes 7 in Draufsicht betrachtet. Zu erkennen ist, dass der mit Austrittskanälen 41 versehener Teilbereich 42 des Dampf-Austrittes 40 und der ebenfalls mit Austrittskanälen 71 versehene Gas-Austritt 7 im Querschnitt betrachtet zusammen eine kreisrunde Fläche bilden. Die Austrittskanäle 41, 71 sind jeweils in Halbkreisform derart angeordnet sein, dass sie 4 gleichweit entfernte volle Kreis-Umfänge mit abnehmenden Radius bilden. Durch diese Austrittskanäle 41, 71 wird das Quellenmaterial und der Metalldampf zeitgleich und senkrecht unmittelbar auf das Substrat 5 geführt.

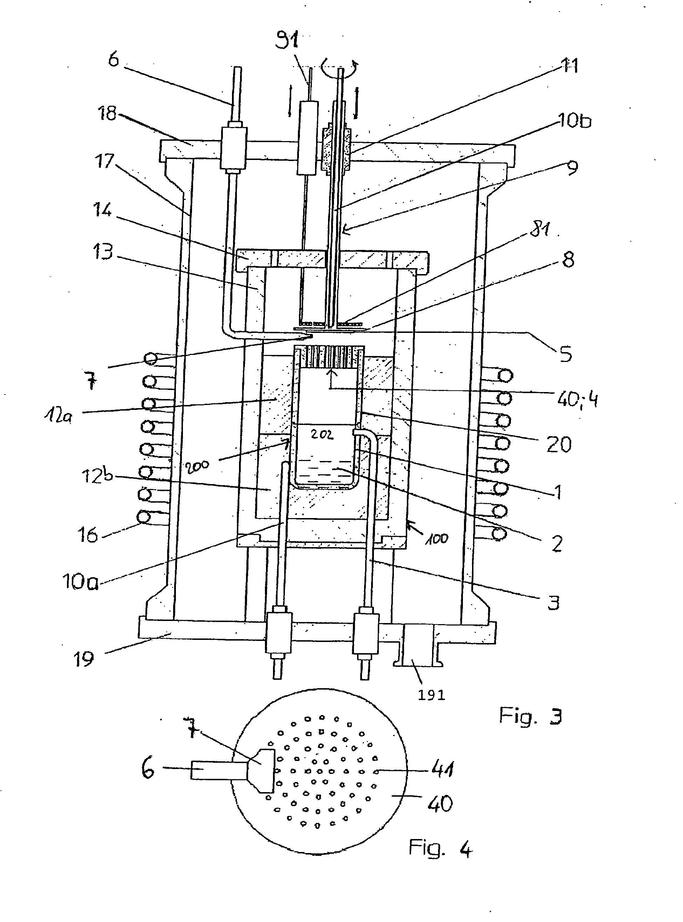

In Figur 3 wird ein anderer Aufbau einer Vorrichtung zur Züchtung von III-Nitrid-Volumen-Kristallen in Schnitt-Darstellung gezeigt. Im Unterschied zur Vorrichtung nach Figur 1 ist hier der Gas-Austritt 7 als Flachdüse ausgebildet, die zwischen Substrat 5 und Dampf-Austritt 40 angeordnet ist. Über den Gas-Austritt 7 wird das Quellenmaterial in horizontaler Richtung entlang des Substrates injiziert. Der Dampf-Austritt 40 besteht hier aus einem zylinderförmigen Graphit-Block 4 mit kreisrundem Querschnitt, in den über den gesamten Querschnitt verteilt Austrittskanäle 41 eingelassen sind, über die der Metalldampf 201 senkrecht auf das Substrat 5 geführt wird.

Figur 4 zeigt die schematische Darstellung des Gas-Austrittes 7 des Dampf-Austrittes 40 der Vorrichtung nach Fig. 3 in Draufsicht. Der Dampf-Austritt 40 hat hier eine kreisrunde Querschnittsfläche. Die Austrittskanäle 41 sind in Kreisform angeordnet.

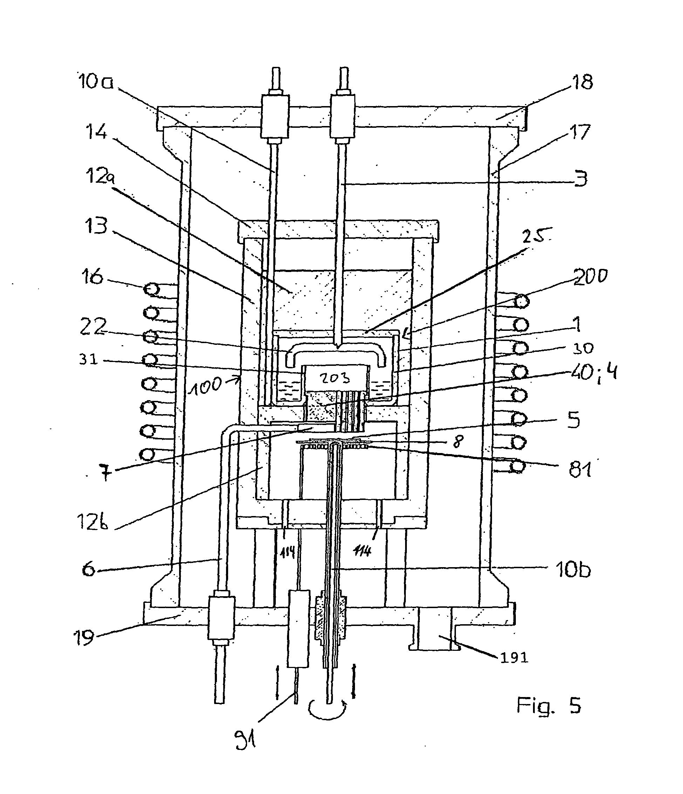

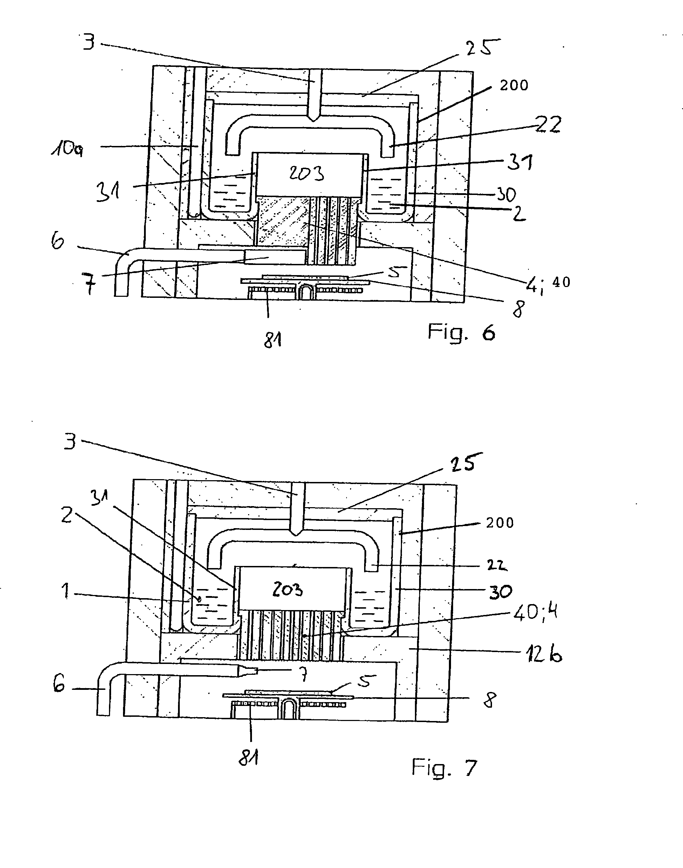

In Figur 5 wird eine weitere schematische Schnitt-Darstellung des Aufbaus einer Vorrichtung zur Züchtung von III-Nitrid-Volumen-Kristallen gezeigt. Im Unterschied zu den Figuren 1 und 3 hat der Schmelztiegel 1 der Verdampfungszelle 200 hier eine andere Ausgestaltung, wie in Figur 6 und in Figur 7 jeweils in vergrößerter Darstellung näher gezeigt wird. Der Schmelztiegel 1 in Figur 5 ist zudem oberhalb des Substrates 5 angeordnet. Entsprechend befindet sich die Verdampfungszelle 200 auch oberhalb des Substrates 5. Der Schmelztiegel 1 weist neben Tiegel-Außen-Wänden 30 zusätzliche Tiegel-Innen-Wände 31 auf, die die Metall-Schmelze 2 von einem Hohlraum 203 oberhalb des Dampf-Austrittes 40 abtrennen. In diesen Hohlraum 203 ist der Graphit-Block 4 mit Austrittskanälen 41 angeordnet. Die Trägergaszuführung 3 weist in Figur 6 und in Figur 7 jeweils zwei Trägergas-Auslässe 22 für das in die Verdampfungszelle 200 eingeleitete Trägergas oberhalb der Schmelze 2 auf. Das Trägergas für den Metalldampf 201 wird über die Trägergaszuführung 3 durch einen Schmelztiegeldeckel 25 und über die zwei symmetrischen Trägergas-Auslässe 22 eingeleitet. Auf diese Weise wird der Metalldampf 201 mit dem Trägergas gemischt und gezwungen, über den Dampf-Austritt 40 hinweg zu driften.
Der Gas-Austritt 7 und der Dampf-Austritt 40 in Figur 6 entsprechen nach Aufbau, Form und Funktion denjenigen in Figur 1; Gas-Austritt 7 und Dampf-Austritte 40 in Figur 7 entsprechen nach Aufbau, Form und Funktion denjenigen der in Figur 3.

Zur Herstellung von Gallium-Nitrid-Volumenkristallen (GaN) mittels der Vorrichtung von Figur 1 wird das rotierende Substrat 5 unter Ammoniak-Strom auf ca. 1000 bis 1200°C erwärmt. Ferner wird das im Schmelztiegel 1 befindliche Gallium mittels einer HF-Spule 16 erhitzt, bis der Verdampfungsbereich bei Temperaturen von 1200 bis 1700 °C erreicht wird. In der Verdampfungszelle 200 wird der Gallium-Dampf erzeugt. Der Gallium-Dampf wird mittels eines durch die Trägergaszuführung 3 geleiteten Stickstoffes durch die Austrittskanäle 41 des Dampf-Austrittes 40 geleitet und im Wesentlichen senkrecht auf das rotierenden Substrat 5 geführt. Gleichzeitig wird Ammoniak-Gas als Quellenmaterial, ggf. mit Stickstoff als Trägergas gemischt, über die Quellenmaterial-Zuführung 6 zum Gas-Austritt 7 geleitet und durch die im Halbkreis angeordneten Austrittskanäle 71 im Wesentlichen senkrecht und zeitgleich mit dem Gallium-Dampf auf das rotierende Substrat 5 geführt. Das Ammoniak kann nicht zur Gallium-Schmelze 2 zurückdiffundieren, sondern muss sich in Richtung Substrat ausbreiten, wo es thermisch unter Freisetzung von atomaren Stickstoff dissoziieren kann, der zur Vermeidung von thermischer Ätzung der entstehenden Kristallkeime wichtig ist.
Gallium-Dampf und Ammoniak bleiben voneinander getrennt, bis sie auf das Substrat 5 auftreffen. Es tritt keine Vorreaktion ein. Ammoniak und Gallium-Dampf vermischen sich und reagieren auf der Substratoberfläche, wobei eine Gallium-Nitrid-Verbindung (GaN) entsteht. Es erfolgt ein Abscheiden und Anwachsen des GaN auf dem Substrat 5, wobei der Züchtungsvorgang über eine bestimmte Dauer ausgeführt wird.
Das rotierende Substrat 5 wird über einen mit Keramik überzogenen Metallwiderstand 81 auf bis zu 1200°C erwärmt. Durch die Rotation des Substrates 5 wird die Homogenität der GaN-Abscheidung sichergestellt. Mit der vertikal bewegbar ausgeführten und in einen Schacht eingelassenen Halterung 9 wird ein definierter Abstand des Substrates 5 zum Dampf-Austritt 40 und Gas-Austritt 7 eingestellt. Durch diese Anordnung werden die strömungsdynamischen Bedingungen in der Reaktionszone optimiert und während der Dickenzunahme des zu züchtenden GaN-Kristalles der optimale Abstand zwischen Kristall und Dampf-Austritt 40 bzw. Gas-Austritt 7 über längere Zeit konstant gehalten.
Die Temperatur des Schmelztiegels 1 wird zum Ende der Züchtungszeit rasch reduziert, um die Gallium-Verdampfung zu beenden, währen der GaN-Volumen-Kristall langsam unter einem Ammoniakstrom abgekühlt wird.

### Bezugszeichenliste

- 1: Schmelztiegel
- 2: Metall-Schmelze
- 3: Trägergaszuführung
- 4: Graphit-Block
- 40: Dampf-Austritt
- 41: Austrittskanäle
- 42: Teilbereich
- 5: Substrat
- 6: Quellenmaterial-Zuführung
- 7: Gas-Austritt
- 71: Austrittskanäle

- 8: Grundplatte
- 81: Heizer
- 9: Halterung
- 91: Heizerzuleitung

- 100: Vertikal-Reaktor
- 10a: Temperaturmesseinrichtung
- 10b: Temperaturmesseinrichtung
- 11: Halterdurchführung
- 12a: Wärme-Isolierung
- 12b: Wärme-Isolierung
- 13: Bornitridzylinder
- 14: Bornitridaufsatz
- 114: Austrittsöffnung

- 16: Wärmequelle
- 17: Quarzzylinder
- 18: Stahl-Flansch
- 19: Stahl-Flansch
- 191: Evakuierungsstutzen

- 20: Dehnungsring
- l: Länge
- 200: Verdampfungszelle
- 202: Gasraum
- 201: Metalldampf
- 203: Hohlraum

- 22: Trägergas-Auslass
- 25: Schmelztiegeldeckel
- 30: Tiegel-Außen-Wand
- 31: Tiegel-Innen-Wand

## Patentansprüche

1. Vorrichtung zur Züchtung von III-Nitrid-Volumen-Kristallen, mindestens umfassend einen von einer Wärmequelle (16) umgebender Quarzzylinder (17), in dem ein Vertikal-Reaktor (100) angeordnet ist, wobei innerhalb des Vertikal-Reaktors (100) eine Verdampfungszelle (200) mit einem Schmelztiegel (1) zur Erzeugung eines Metalldampfes (201) aus einer Metallschmelze und ein über eine Halterung (9) rotierbar gehaltertes Substrat (5) angeordnet sind und der Vertikal-Reaktor Zuführungen (3, 6) zur Einleitung von Ammoniak und einem Trägergas für den Metalldampf (201) aufweist, derart, dass eine direkte und voneinander getrennte Zuführung von Ammoniak über einen Gas-Austritt (7) und Metalldampf über einen Dampf-Austritt (40) auf das Substrat (5) erfolgt,
**dadurch gekennzeichnet, dass**
die Verdampfungszelle (200) einen Graphit-Block (4) umfasst, der die Verdampfungszelle (200) abschließt und Austrittskanäle (41) für den Metalldampf (201) aufweist, die den Dampf-Austritt (40) bilden.

2. Vorrichtung nach Anspruch 1,
**dadurch gekennzeichnet, dass**
ein mit Austrittskanälen (41) versehener Teilbereich (42) des Graphit-Blockes (4) eine halbkreisrunde Querschnittsfläche bildet.

3. Vorrichtung nach Anspruch 1 oder 2,
**dadurch gekennzeichnet, dass**
die Verdampfungszelle (200) einen oberhalb des Schmelztiegels (1) angeordneten Dehnungsring (20) und den darüber angeordneten, die Verdampfungszelle (200) abschließenden Graphit-Block (4) umfasst.

4. Vorrichtung nach Anspruch 3,
**dadurch gekennzeichnet, dass**
der Dehnungsring (20) vertikal um eine Länge (1) verstellbar ausgeführt ist.

5. Vorrichtung nach Anspruch 1 oder 2,
**dadurch gekennzeichnet, dass**
die Verdampfungszelle (200) einen Schmelztiegel (1) umfasst, in den ein von Tiegel-Innen-Wänden (31) umgebender Hohlraum (203) zur Aufnahme des Graphit-Blockes (4) eingelassen ist, der Graphit-Block (4) den Schmelztiegel (1) nach unten abschließt und der Schmelztiegel (1) einen Schmelztiegeldeckel (25) aufweist.

6. Vorrichtung nach einem der Ansprüche 1 bis 5,
**dadurch gekennzeichnet, dass**
der Schmelztiegel (1), der Dehnungsring (20), der Graphit-Block (4) und der Schmelztiegeldeckel (25) der Verdampfungszelle (200) aus Graphit gebildet sind, wobei der Graphit mit einer Siliziumcarbid- oder Siliziumnitrid-Beschichtung versehen ist.

7. Vorrichtung nach Anspruch 1,
**dadurch gekennzeichnet, dass**
der Gas-Austritt (7) als ein Hohlkörper mit Austrittskanälen (71) oder als Flachdüse ausgebildet ist.

## Claims

1. A device for growing III nitride bulk crystals, at least comprising: a quartz cylinder (17) that is surrounded by a heat source (16), in which quartz cylinder a vertical reactor (100) is arranged, wherein an evaporation cell (200) including a melting crucible (1) for producing a metal vapour (201) from a molten metal and a substrate (5) that is held by a holder (9) so as to be rotatable are arranged inside the vertical reactor (100) and the vertical reactor comprises inlets (3, 6) for the supply of ammonia and of a carrier gas for the metal vapour (201), in such a manner that ammonia, via a gas outlet (7), and metal vapour, via a vapour outlet (40), are supplied onto the substrate (5) directly and separately from each other,
**characterized in that**
the evaporation cell (200) comprises a graphite block (4) that seals the evaporation cell (200) and comprises outlet channels (41) for the metal vapour (201), which outlet channels form the vapour outlet (40).

2. A device according to claim 1,
**characterized in that**
a part (42) of the graphite block (4), which part is provided with outlet channels (41), forms a semicircular cross-sectional area.

3. A device according to claim 1 or 2,
**characterized in that**
the evaporation cell (200) comprises an expansion ring (20) that is arranged above the melting crucible (1) and the graphite block (4) that is arranged above said expansion ring and seals the evaporation cell (200).

4. A device according to claim 3,
**characterized in that**
the expansion ring (20) is designed to be vertically adjustable by a length (1).

5. A device according to claim 1 or 2,
**characterized in that**
the evaporation cell (200) comprises a melting crucible (1) in which a cavity (203) that is surrounded by inner crucible walls (31) is provided to receive the graphite block (4), the graphite block (4) seals the melting crucible (1) on the bottom thereof, and the melting crucible (1) comprises a melting crucible lid (25).

6. A device according to any one of claims 1 to 5,
**characterized in that**
the melting crucible (1), the expansion ring (20), the graphite block (4) and the melting crucible lid (25) of the evaporation cell (200) are made of graphite, wherein said graphite is provided with a silicon carbide or silicon nitride coating.

7. A device according to claim 1,
**characterized in that**
the gas outlet (7) is designed as a hollow body having outlet channels (71) or as a flat nozzle.

## Revendications

1. Dispositif pour la croissance de cristaux de III-nitrure volumineux, comprenant au moins un cylindre en quartz (17) entouré par une source de chaleur (16), dans lequel est discosé un réacteur vertical (100), à l'intérieur du réacteur vertical (100) étant disposés une cellule d'évaporation (200) avec un creuset (1) destiné à produire une vapeur métallique (201) d'une fonte métallique et un substrat (5) monté à rotation par moyen d'un support (9) et le réacteur vertical présentant des amenées (3, 6) pour l'alimentation en ammoniac et en un gaz porteur pour la vapeur métallique (201), de façon que le substrat(5) est alimenté de manière directe et séparée en ammoniac par une sortie de gaz (7) et en vapeur métallique par une sortie de vapeur (40),
**caractérisé en ce que**
la cellule d'évaporation (200) comprend un bloc de graphite (4) clôturant la cellule d'évaporation (200) et des canaux de sortie (41) pour la vapeur métallique (201) formant la sortie de vapeur (40).

2. Dispositif selon la revendication 1,
**caractérisé en ce**
**qu'**une section (42) du bloc de graphite (4) dotée de canaux de sortie (41) forme une surface de section hémicirculaire.

3. Dispositif selon la revendication 1 ou 2,
**caractérisé en ce**
**que** la cellule d'évaporation (200) comprend un anneau de dilatation (20) disposé au-dessus du creuset (1) et le bloc de graphite (4) qui est disposé en dessus et clôture la cellule d'évaporation (200).

4. Dispositif selon la revendication 3,
**caractérisé en ce que**
l'anneau de dilatation (20) est réalisé de manière ajustable d'une longueur (1).

5. Dispositif selon la revendication 1 ou 2,
**caractérisé en ce**
**que** la cellule d'évaporation (200) comprend un creuset (1), dans lequel est encastrée une cavité 203) entourée par des parois intérieures (31) du creuset pour recevoir le bloc de graphite (4), que le bloc de graphite (4) clôture le creuset (1) vers le bas et que le creuset (1) comporte un couvercle de creuset (25).

6. Dispositif selon une des revendications 1 à 5,
**caractérisé en ce**
**que** le creuset (1), l'anneau de dilatation (20), le bloc de graphite (4) et le couvercle du creuset (25) de la cellule d'évaporation (200) sont réalisés en graphite, le graphite étant doté d'une couche de carbure de silicium ou de nitrure de silicium.

7. Dispositif selon la revendication 1,
**caractérisé en ce**
**que** la sortie de gaz (7) est réalisée sous forme d'un corps creux avec des canaux de sortie (71) ou sous forme d'une buse plate.
